# EUROPÄISCHE PATENTANMELDUNG

(11) **EP 1 971 193 A1**
(43) Veröffentlichungstag der Anmeldung: **17.09.2008**
(21) Anmeldenummer: 07005449.9
(22) Anmeldetag: 16.03.2007
(51) Int. Cl.: H05K 1/16

(54) **Leiterplattenbauteil zum Herstellen von Planarinduktivitäten mit geschlossenen Kernformen**

(71) Anmelder: HÜTTINGER Elektronik GmbH + Co. KG, 79111 Freiburg (DE)
(72) Erfinder: Kirchmeier, Thomas, 79331 Teningen (DE); Knaus, Hanns-Joachim, 79312 Emmendingen (DE)
(74) Vertreter: Kohler Schmid Möbus

(57) **Zusammenfassung**

Ein Leiterplattenbauteil (14) weist auf: wenigstens ein erstes Leiterplattenelement (6), das ein dielektrisches Substrat (11) mit mindestens einer auf diesem Substrat angeordneten ersten Leiterbahn (12.1, 12.2) umfasst, an dem mindestens ein geschlossenes einteiliges Magnetfeld verstärkendes Element (13.1-13.4) angeordnet ist, das die erste Leiterbahn (12.1, 12.2) zumindest abschnittweise umgibt; und wenigstens ein zweites Leiterplattenelement (1), das ein dielektrisches Substrat mit mindestens einer Aussparung (3.1-3.4), die zum Einstecken des ersten Leiterplattenelements (6) ausgebildet ist, und mit mindestens einer auf diesem Substrat angeordneten, sich bis zu der Aussparung erstreckenden zweiten Leiterbahn umfasst; wobei das erste und das zweite Leiterplattenelement (6, 1) so ineinander gesteckt sind, dass die erste Leiterbahn (12.1, 12.2) die zweite Leiterbahn ergänzt.

## Beschreibung

Die vorliegende Erfindung betrifft ein Leiterplattenbauteil, das die Integration von Planarinduktivitäten mit geschlossenen Kernformen ermöglicht.

Induktive Bauteile werden häufig mit magnetischen, insbesondere ferritischen Materialien umgeben, um die Induktivität der Bauteile zu erhöhen. Herkömmliche drahtbewickelte Bauteile, bei denen ein Spulendraht um einen Ferritkern gewickelt wird, sind nur in Handarbeit fertigbar, dementsprechend trotz geringer Materialkosten sehr teuer und zudem mechanisch nur ungenau reproduzierbar. Induktive Planarbauteile oder Planarinduktivitäten, d.h. Bauteile, bei denen der Leiter als Leiterbahn auf einer Leiterplatte ausgebildet ist, bieten den Vorteil einer guten Reproduzierbarkeit in der Fertigung.

Um bei solchen Bauteilen die Induktivität zu erhöhen, ist bekannt, einen zweiteiligen Ferritkern so zusammenzufügen, dass er die als Leiterbahn ausgebildete(n) Wicklung(en) eines Spulen-Bauteils umschließt. Diese Vorgehensweise ist jedoch aufwändig und macht die Verwendung speziell zweiteilig ausgebildeter Ringkerne erforderlich. Die Ferritkerne können zwar prinzipiell in beliebiger Bauform (Kernform) gestaltet werden, allerdings müssen für jede Bauform spezielle Formen gefertigt werden, die Hitze und hohem Druck standhalten müssen. Diese Formen sind sehr kostenaufwändig und für kleine Serien nicht wirtschaftlich. Gerade für kleine Serien ist es daher von Vorteil, am Markt verfügbare Standard-Ferrite zu verwenden, die in der Regel in geschlossener ringförmiger Bauweise, d.h. als geschlossene Kernformen angeboten werden.

Der Erfindung liegt die Aufgabe zu Grunde, ein Leiterplattenbauteil anzugeben, bei dem die Integration induktiver Planarbauteile kostengünstig unter Verwendung geschlossener Kernformen in standardisierten Fertigungsschritten möglich ist.

Die Aufgabe wird gelöst durch ein Leiterplattenbauteil mit den Merkmalen des Patentanspruchs 1. Vorteilhafte Weiterbildungen des erfindungsgemäßen Leiterplattenbauteils sind in den Unteransprüchen angegeben, deren Wortlaut hiermit durch Bezugnahme in die Beschreibung aufgenommen wird, um unnötige Textwiederholungen zu vermeiden.

Ein erfindungsgemäßes Leiterplattenbauteil zeichnet sich aus durch wenigstens ein erstes Leiterplattenelement, das ein dielektrisches Substrat mit mindestens einer auf diesem Substrat angeordneten ersten Leiterbahn umfasst, an dem mindestens ein geschlossenes einteiliges Magnetfeld verstärkendes Element angeordnet ist, das die erste Leiterbahn zumindest abschnittweise umgibt; und durch wenigstens ein zweites Leiterplattenelement, das ein dielektrisches Substrat mit mindestens einer Aussparung, die zum Einstecken des ersten Leiterplattenelements ausgebildet ist, und mit mindestens einer auf diesem Substrat angeordneten, sich bis zu der Aussparung erstreckenden zweiten Leiterbahn umfasst; wobei das erste und das zweite Leiterplattenelement so ineinander gesteckt sind, dass die erste Leiterbahn die zweite Leiterbahn ergänzt.

Erfindungsgemäß wird somit ein Leiterplattenbauteil vorgeschlagen, das aus mindestens einem Leiterplattenelement in Form einer Grundplatine und mindestens einem weiteren Leiterplattenelement in Form einer Steckplatine besteht. Im Zuge von Ausgestaltungen der vorliegenden Erfindung weist die Grundplatine eine oder mehrere Aussparungen (z.B. Durchbrüche) und die Steckplatine mindestens eine dazu komplementäre Einsteckstelle auf, beispielsweise in Form eines geeignet ausgebildeten Vorsprungs. Auf der Grundplatine verläuft mindestens eine Leiterbahn, die sich bis zu der Aussparung erstreckt und insbesondere an der Aussparung beziehungsweise durch die Aussparung unterbrochen ist. Auf der Steckplatine verläuft mindestens eine Leiterbahn, die bei der Einsteckstelle endet. Die Leiterbahn der Steckplatine ist von mindestens einem geschlossenen einteiligen Magnetfeld verstärkenden Element, insbesondere einem ringförmigen Ferritkern, umgeben. Unter einem ringförmigen Ferritkern ist dabei ein Ferritkern mit runder oder eckiger Außenkontur zu verstehen, der eine beliebig geformte, insbesondere runde Bohrung aufweist.

Die Steckplatine ist so in die Grundplatine gesteckt, dass die Enden der Leiterbahnen auf Grund- und Steckplatine aneinander stoßen oder zumindest eng beabstandet angeordnet sind, und wird an diesen Stoßstellen oder Verbindungsstellen mit der Grundplatine verlötet, vorzugsweise durch Wellenlötung.

Ein wesentliches Merkmal von Ausgestaltungen der erfindungsgemäßen Anordnung besteht somit darin, dass offene Leiterbahnen, z.B. Spulenwindungen, der Steckplatine durch Leitersegmente der Grundplatine ergänzt werden oder umgekehrt, wodurch die Bauteile in Standardprozessen, d.h. insbesondere unter Verwendung von Standard-Bauelementen, wie geschlossenen Ferritkernen, bestückt und gelötet werden können. Die Steckplatine wird vorzugsweise wie ein gewöhnliches Bauteil der Grundplatine (z.B. ein Widerstand, ein Stecker oder ein Transistor) in einem Standardprozess auf der Bestückseite der Grundplatine bestückt und auf der Lötseite verlötet, ebenso wie auch die Kontakte der übrigen Bauteile auch durch Bohrungen in der Grundplatine gesteckt und auf der Lötseite mit Verbindungen auf der Grundplatine verlötet werden.

Weitere Vorteile und Eigenschaften der vorliegenden Erfindung ergeben sich aus der nachfolgenden Beschreibung von Ausführungsbeispielen anhand der Zeichnung. Aus den einzelnen Ausführungsbeispielen zu entnehmende Merkmale können einzeln oder in Kombination bei Ausgestaltungen der vorliegenden Erfindung verwirklicht sein. Es zeigt:
- Fig. 1: ein Leiterplattenelement einer Ausgestaltung des erfindungsgemäßen Leiterplattenbauteils in der Draufsicht;
- Fig. 2: das Leiterplattenelement gemäß Fig. 1 von unten betrachtet und mit einem eingesteckten zweiten Leiterplattenelement;
- Fig. 3: eine erste Schnittansicht eines erfindungsgemäßen Leiterplattenbauteils;und
- Fig. 4: eine weitere Schnittansicht des Leiterplattenbauteils gemäß Fig. 3.

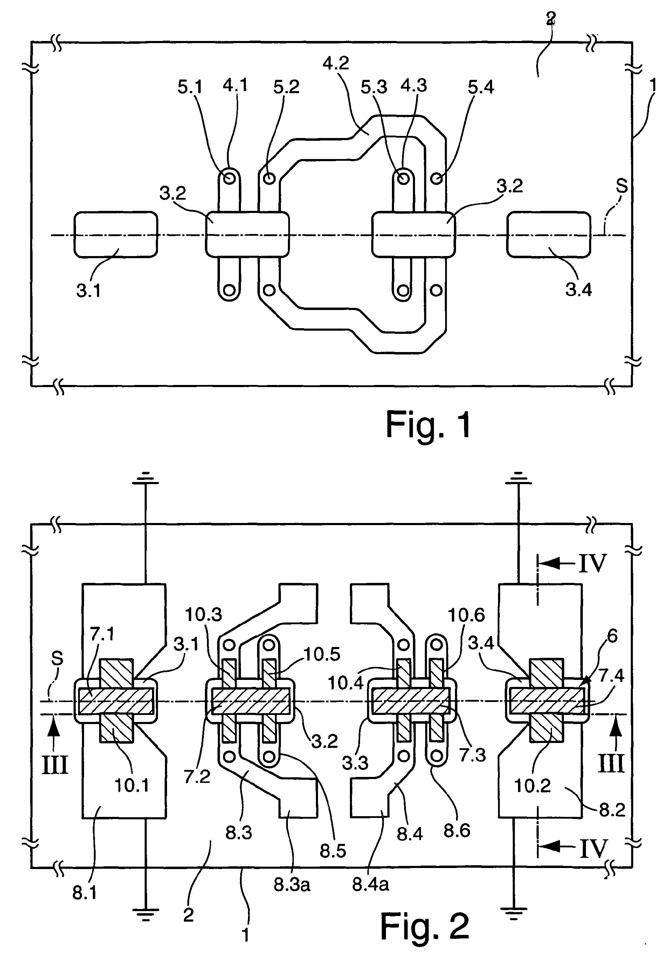

Fig. 1 zeigt in der Draufsicht einen Ausschnitt aus einem Leiterplattenelement 1 bei einer Ausgestaltung des erfindungsgemäßen Leiterplattenbauteils. Das Leiterplattenelement 1 ist aus einem dielektrischen Substrat 2 ausgebildet und fungiert als Grundplatine. Die Grundplatine erstreckt sich über den gezeigten Ausschnitt hinaus und ist auf ihrer in Fig. 1 dargestellten Vorderseite (Bestückseite) mit verschiedenen (nicht gezeigten) Bauteilen bestückt. Das Leiterplattenelement 1 weist im gezeigten Ausschnitt eine Reihe von Aussparungen in Form von Durchbrüchen 3.1-3.4 auf. Die Durchbrüche 3.1-3.4 sind auf einer Linie S angeordnet, welche zugleich eine Symmetrieebene des gezeigten Ausschnitts des Leiterplattenelements 1 bildet. Zur Vereinfachung der Darstellung werden daher nachfolgend die weiteren Strukturen des Leiterplattenelements 1 nur für einen Bereich oberhalb der Symmetrieebene (Linie S) beschrieben, sind jedoch unterhalb derselben ebenfalls identisch vorhanden.

Auf dem dielektrischen Substrat 2 weist das Leiterplattenelement 1 eine Anzahl von metallischen Leiterbahnen oder Leiterbahnabschnitten 4.1-4.3 auf. Die Leiterbahnen 4.1-4.3 reichen jeweils mit wenigstens einem ihrer Enden bis an einen der Durchbrüche 3.2, 3.3 heran. Speziell reicht die Leiterbahn 4.1 bis an den Durchbruch 3.2 heran, und die Leiterbahn 4.3 reicht bis an den Durchbruch 3.3 heran. Die Leiterbahn 4.2 ist im Wesentlichen bogenförmig ausgebildet und reicht mit einem ihrer Enden an den Durchbruch 3.2 und mit ihrem anderen Ende an den Durchbruch 3.3 heran. Im Bereich der Leiterbahnen 4.1-4.3 weist das Leiterplattenelements 1 weiterhin eine Anzahl von Durchkontaktierungslöchern 5.1-5.4 auf, die zum elektrisch leitenden Verbinden der Leiterbahnen 4.1-4.3 mit Leiterbahnen auf einer Rückseite des Leiterplattenelements 1 beziehungsweise des Substrats 2 dienen. Letztere sind in der nachfolgenden Fig. 2 dargestellt.

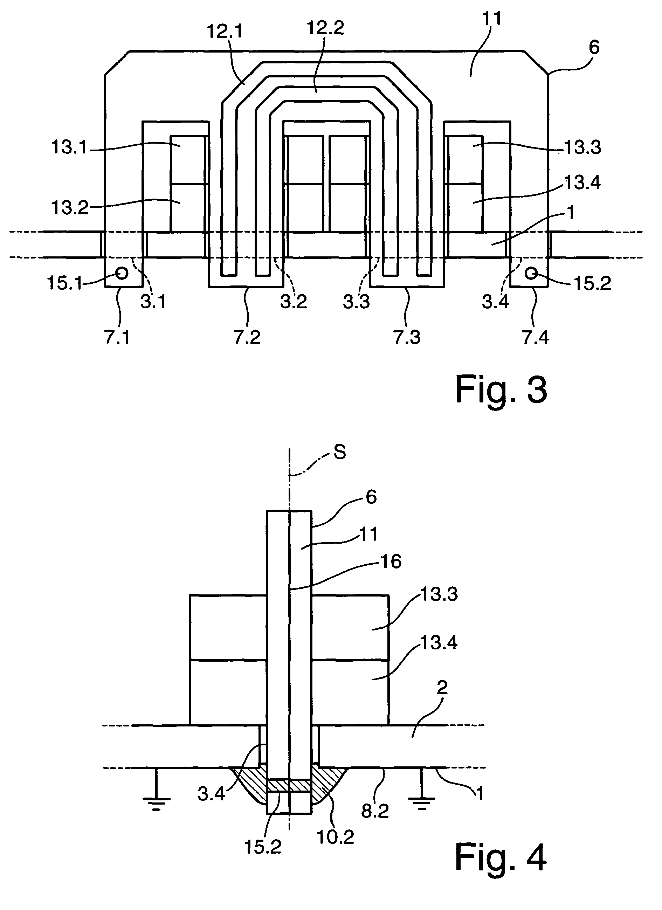

Fig. 2 zeigt das Leiterplattenelement 1 gemäß Fig. 1 von unten betrachtet und mit einem eingesteckten weiteren Leiterplattenelement 6, das als Steckplatine fungiert und von dem in der gewählten Darstellung lediglich vier Vorsprünge 7.1-7.4 zu erkennen sind (vergleiche Fig. 3). Das weitere Leiterplattenelement 6 ist mit den Vorsprüngen 7.1-7.4 in die Durchbrüche 3.1-3.4 des Leiterplattenelements 1 eingesteckt und senkrecht, d.h. unter einem Winkel von 90° zu diesem angeordnet. Das Leiterplattenelement 1 weist auf seiner Rückseite (Lötseite) weitere Leiterbahnen beziehungsweise Leiterbahnabschnitte 8.1-8.6 auf, die wiederum mit wenigstens einem ihrer jeweiligen Enden bis an die Durchbrüche 3.1-3.4 heranreichen. Aus Symmetriegründen wird vorliegend wiederum nur die Ausgestaltung der Rückseite des Leiterplattenelements 1 auf einer Seite (speziell unterhalb) der Symmetrieebene (Linie S) beschrieben.

Die Leiterbahnabschnitte 8.1, 8.2 sind flächig ausgebildet. Sie dienen als Abschirmpotenzial-Leiterstrukturen und sind im Betrieb des Leiterplattenbauteils geerdet, das heißt mit einem Massepotenzial verbunden. Dies erfolgt in der Regel über Durchkontaktierung auf eine Innenlage des Leiterplattenelements 1. Die Leiterbahnen 8.3, 8.4 reichen mit ihrem einen Ende an den Durchbruch 3.2 beziehungsweise an den Durchbruch 3.3 heran und führen mit ihrem jeweils anderen Ende zu anderen Bauteilen, die auf dem Leiterplattenelement 1 angeordnet sind (in Fig. 2 nicht gezeigt). Über die Durchkontaktierungslöcher 5.1-5.4 sind elektrisch leitende Verbindungen zwischen den Leiterbahnen auf der Vorderseite des Leiterplattenelements 1 (Fig. 1) und den Leiterbahnen auf der Rückseite des Leiterplattenelements 1 (Fig. 2) geschaffen. Dabei ist die Leiterbahn 4.1 mit der Leiterbahn 8.3 verbunden; die Leiterbahn 4.2 ist mit den Leiterbahnen 8.5, 8.6 verbunden; und die Leiterbahn 4.3 ist mit der Leiterbahn 8.4 verbunden.

Wie der Fachmann erkennt, bilden die bislang beschriebenen Leiterbahnstrukturen auf der Vorder- und Rückseite des Leiterplattenelements 1 keinen durchgängigen Leitungspfad, da sie durch die Durchbrüche 3.2, 3.3 unterbrochen sind. Die Komplettierung der Leiterbahnstrukturen zu einem durchgängigen Leitungspfad erfolgt mittels zusätzlicher Leiterbahnen des weiteren Leiterplattenelements 6, die in Fig. 2 nicht dargestellt sind und die weiter unten unter Bezugnahme auf Fig. 3 genauer beschrieben werden. Zu diesem Zweck sind die Leiterbahnen 8.3-8.6 auf der Rückseite des Leiterplattenelements 1 über Lötverbindungen 10.3-10.6 mit Leiterbahnen des weiteren Leiterplattenelements 6 (vergleiche Fig. 3) verbunden. Lötverbindungen 10.1, 10.2 von den Leiterbahnen 8.1, 8.2 zu dem weiteren Leiterplattenelement 6 dienen zum Anschließen einer in dem weiteren Leiterplattenelement 6 vorgesehenen Abschirmstruktur (in Fig. 2 nicht gezeigt) an das Massepotenzial, worauf ebenfalls weiter unten anhand der Figuren 3 und 4 noch genauer eingegangen wird. Die Lötverbindungen 10.1-10.6 werden vorzugsweise durch Wellenlötung hergestellt.

Fig. 3 zeigt eine Schnittansicht etwa entlang einer Linie III-III in Fig. 2. Dargestellt ist das weitere Leiterplattenelement 6, das im Wesentlichen kammartig mit den bereits erwähnten Vorsprüngen 7.1-7.4 ausgebildet ist. Wie das Leiterplattenelement 1 ist das weitere Leiterplattenelement 6 aus einem dielektrischen Substrat 11 gebildet und weist an seiner Oberfläche eine Anzahl von Leiterbahnen 12.1, 12.2 auf. Die Leiterbahnen 12.1, 12.2 sind im Wesentlichen U-förmig ausgebildet und verlaufen parallel zueinander. Dabei ist ein jeweils erster freier Schenkel der U-förmigen Leiterbahnen 12.1, 12.2 im Bereich des Vorsprungs 7.2 angeordnet, während der jeweils andere freie Schenkel der U-förmigen Leiterbahnen 12.1, 12.2 im Bereich des Vorsprungs 7.3 angeordnet ist. Die Leiterbahnen 12.1, 12.2 erstrecken sich fast bis zur jeweiligen Spitze der Vorsprünge 7.2, 7.3, so dass sie sich, wenn das weitere Leiterplattenelement 6 in das Leiterplattenelement 1 eingesteckt ist, durch die Durchbrüche 3.2, 3.3 hindurch bis auf die Rückseite des Leiterplattenelements 1 (vergleiche Fig. 2) erstrecken und dort mittels der bereits erwähnten Lötverbindungen 10.3-10.6 mit den Leiterbahnen 8.3-8.6 verbunden werden können. Aufgrund der Durchkontaktierungslöcher 5.1-5.4 ergibt sich so ein durchgängiger Leitungspfad in Form einer zweiwindigen Spule, wobei die Anschlusspads 8.3a, 8.4a (Fig. 2) als Spulenanschlüsse fungieren.

Um die Vorsprünge 7.2, 7.3 des weiteren Leiterplattenelements 6 herum sind jeweils zwei Magnetfeld verstärkende Elemente 13.1, 13.2; 13.3, 13.4 in Form von Ringen aus einem ferritischen Material (Ferritkerne) angeordnet, so dass die Leiterbahnen 12.1, 12.2 sich durch die Ferritkerne 13.1-13.4 hindurch erstrecken und Letztere somit zur Verstärkung eines durch die Spule erzeugten Magnetfeldes dienen, ohne dass hierzu ein aufwändiges Umwickeln eines Spulenkörpers oder ein Öffnen der Ferritkerne erforderlich ist.

Wenn die Vorsprünge 7.1-7.4 des weiteren Leiterplattenelements 6 mit "aufgefädelten" Ferritkernen 13.1-13.4 in die Durchbrüche 3.1-3.4 des Leiterplattenelements1 eingesteckt sind, ist auf diese Weise ein Leiterplattenbauteil 14 gebildet, auf dem in einfacher Weise Planarinduktivitäten mit geschlossenen Kernformen integriert sind.

Bei der gezeigten Ausgestaltung der vorliegenden Erfindung ist auf der Rückseite des weiteren Leiterplattenelements 6 gemäß Fig. 3 eine identische Leiterbahnstruktur (nicht sichtbar) mit parallelen, U-förmigen Leiterbahnen vorgesehen, die mit den erwähnten symmetrischen Leiterbahnstrukturen auf der Vorder- und Rückseite des Leiterplattenelements 1 elektrisch verbunden sind, wie oben für die Leiterbahnen 12.1, 12.2 detailliert beschrieben wurde. Auf diese Weise stellt das Leiterplattenbauteil 14 einen Übertrager mit 2 x 2 Windungen dar. Vorliegend ist dieser Übertrager als geschirmter Übertrager ausgebildet, wozu in dem weiteren Leiterplattenelement 6 eine Abschirmstruktur in Form einer Abschirmschicht vorgesehen ist (vergleiche Fig. 4), deren Gesamtformgebung der kammartigen Formgebung des weiteren Leiterplattenelements 6 entspricht. An den Vorsprüngen 7.1, 7.4 sind Kontaktierungslöcher 15.1, 15.2 zum elektrischen Kontaktieren der Abschirmschicht vorgesehen, die sich im gesteckten Zustand des Leiterplattenbauteils 14 unterhalb des Leiterplattenelements 1 befinden, so dass dort mittels der Lötverbindungen 10.1, 10.2 eine elektrisch leitfähige Verbindung zwischen der Abschirmstruktur und den geerdeten Leiterbahnen 8.1, 8.2 herstellbar ist. Die Abschirmstruktur ist in der nachfolgenden Fig. 4 im Querschnitt dargestellt.

Fig. 4 zeigt eine Schnittansicht etwa entlang der Linie IV-IV in Fig. 2. In dieser Darstellung ist die inmitten des weiteren Leiterplattenelements 6 angeordnete Abschirmstruktur 16 in Form einer Abschirmschicht deutlich erkennbar. Sie ist über das Kontaktierungsloch 15.2 und die Lötverbindung 10.2 mit der Leiterbahn 8.2 verbunden, die geerdet, das heißt an das Massepotenzial angeschlossen ist. Durch die dargestellte Ausgestaltung der Abschirmstruktur ist sichergestellt, dass diese keine geschlossene Windung bildet und sich somit nicht nachteilig auf den Betrieb des Übertragers auswirkt. Die übrigen Lötverbindungen gemäß Fig. 2, d.h. Lötverbindungen 10.1, 10.3-10.6 sind im Wesentlich vergleichbar der in Fig. 4 gezeigten Lötverbindung 10.2 ausgebildet.

Die gezeigte Steckplatine (Leiterplattenelement 6) weist somit auf jeder Seite zwei Planarwicklungen (Leiterbahnen 12.1, 12.2) senkrecht zur Grundplatine (Leiterplattenelement 1) auf, zwischen denen sich eine geerdete Schirmebene (Abschirmstruktur) befindet. Wie bereits erwähnt und der Fig. 3 entnehmbar, enden die Planarwicklungen etwas oberhalb der Seitenkante der Steckplatine, d.h. in einem gewissen Abstand von den Enden der Vorsprünge 7.2, 7.3, die in komplementäre Ausnehmungen (Durchbrüche 3.2, 3.3) in der Grundplatine gesteckt sind. Im gesteckten Zustand erstrecken sich die Planarwicklungen so weit auf die Unterseite der Grundplatine (Rückseite des Leiterplattenelements 1), dass die zusammengehörigen Leiterbahnen von Steck- und Grundplatine durch Wellenlötung verbunden werden können. Die Steckplatine wird also ebenso wie die übrigen Bauteile der Grundplatine in einem Standardprozess auf der Bestückseite der Grundplatine bestückt und auf deren Lötseite verlötet.

Es ist selbstverständlich, das die vorliegende Erfindung nicht auf die exemplarisch beschriebene Ausgestaltung in Form eines Übertragers beschränkt ist, sondern dass auch allgemeine Planarinduktivitäten mit geschlossenen Kernformen unter die beigefügten Patentansprüche fallen. Darüber hinaus können die verschiedenen Leiterplattenelemente insbesondere auch unter einem anderen Winkel als 90° in einander gesteckt sein.

## Patentansprüche

1. Leiterplattenbauteil (14), aufweisend:
wenigstens ein erstes Leiterplattenelement (6), das ein dielektrisches Substrat (11) mit mindestens einer auf diesem Substrat angeordneten ersten Leiterbahn (12.1, 12.2) umfasst, an dem mindestens ein geschlossenes einteiliges Magnetfeld verstärkendes Element (13.1-13.4) angeordnet ist, das die erste Leiterbahn (12.1, 12.2) zumindest abschnittweise umgibt;
wenigstens ein zweites Leiterplattenelement (1), das ein dielektrisches Substrat (2) mit mindestens einer Aussparung (3.1-3.4), die zum Einstecken des ersten Leiterplattenelements (6) ausgebildet ist, und mit mindestens einer auf diesem Substrat angeordneten, sich bis zu der Aussparung erstreckenden zweiten Leiterbahn (4.1-4.3, 8.3-8.6) umfasst;
wobei das erste und das zweite Leiterplattenelement (6, 1) so ineinander gesteckt sind, dass die erste Leiterbahn (12.1, 12.2) die zweite Leiterbahn (4.1-4.3, 8.3-8.6) ergänzt.

2. Leiterplattenbauteil (14) nach Anspruch 1, **dadurch gekennzeichnet, dass** die erste Leiterbahn (12.1, 12.2) ein erstes Ende und ein zweites Ende aufweist und dass die zweite Leiterbahn (4.1-4.3, 8.3-8.6) durch die Aussparung (3.2, 3.3) unterbrochen und mittels der ersten Leiterbahn komplettiert ist.

3. Leiterplattenbauteil (14) nach einem der vorhergehenden Ansprüche, **dadurch gekennzeichnet, dass** die Aussparung (3.1-3.4) als Durchbruch in dem dielektrischen Substrat (2) des zweiten Leiterplattenelements (1) ausgebildet ist.

4. Leiterplattenbauteil (14) nach einem der vorhergehenden Ansprüche, **dadurch gekennzeichnet, dass** das Magnetfeld verstärkende Element (13.1-13.4) ringförmig ausgebildet ist und aus Ferrit besteht.

5. Leiterplattenbauteil (14) nach einem der vorhergehenden Ansprüche, **dadurch gekennzeichnet, dass** die erste Leiterbahn (12.1, 12.2) im Wesentlichen U-förmig ausgebildet ist.

6. Leiterplattenbauteil (14) nach einem der vorhergehenden Ansprüche, **dadurch gekennzeichnet, dass** die ersten und zweiten Leiterbahnen (12.1, 12.2; 4.1-4.3, 8.3-8.6) metallische Leiterbahnen sind.

7. Leiterplattenbauteil (14) nach einem der vorhergehenden Ansprüche, **dadurch gekennzeichnet, dass** die erste Leiterbahn (12.1, 12.2) und die zweite Leiterbahn (4.1-4.3, 8.3-8.6) an einer Anzahl von Verbindungsstellen miteinander verlötet sind, insbesondere durch Wellenlötung.

8. Leiterplattenbauteil (14) nach einem der vorhergehenden Ansprüche, **dadurch gekennzeichnet, dass** auf einer Vorderseite und einer Rückseite des dielektrischen Substrats (11) des ersten Leiterplattenelements (6) und/oder des dielektrischen Substrats (2) des zweiten Leiterplattenelements (1) jeweils mindestens eine Leiterbahn (4.1-4.3, 8.3-8.6, 12.1-12.2) angeordnet ist und dass in dem entsprechenden ersten und/oder zweiten Leiterplattenelement (6, 1) eine Abschirmstruktur (15.1, 15.2, 16) vorgesehen ist, die in dem gesteckten Zustand mit einer Abschirmpotential-Leiterstruktur (8.1, 8.2) an dem jeweils anderen Leiterplattenelement verbunden, insbesondere verlötet ist.

9. Leiterplattenbauteil (14) nach einem der vorhergehenden Ansprüche, **dadurch gekennzeichnet, dass** das erste und das zweite Leiterplattenelement (6; 1) unter einem endlichen Winkel, vorzugsweise unter einem Winkel von 90°, ineinander gesteckt sind.

10. Leiterplattenbauteil (14) nach einem der vorhergehenden Ansprüche, **dadurch gekennzeichnet, dass** eine Mehrzahl von ersten Leiterbahnen (12.1, 12.2) gemeinsam von dem wenigstens einen Magnetfeld verstärkenden Element (13.1-13.4) umgeben sind.

11. Leiterplattenbauteil (14) nach Anspruch 10, **dadurch gekennzeichnet, dass** die Mehrzahl von ersten Leiterbahnen (12.1, 12.2) mit einer Mehrzahl von zweiten Leiterbahnen(4.1-4.3, 8.3-8.6) eine mehrwindige Spule bildet.

12. Verfahren zur Herstellung eines Leiterplattenbauteils (14) nach einem der vorhergehenden Ansprüche, umfassend die Schritte:
Vorsehen eines ersten Leiterplattenelements (6), das ein dielektrisches Substrat (11) mit mindestens einer auf diesem Substrat angeordneten ersten Leiterbahn (12.1, 12.2) umfasst,
Umgeben wenigstens eines Abschnitts der ersten Leiterbahn (12.1, 12.2) mit mindestens einem geschlossenen einteiligen Magnetfeld verstärkenden Element (13.1-13.4),
Vorsehen eines zweiten Leiterplattenelements (1), das ein dielektrisches Substrat (2) mit mindestens einer Aussparung (3.1-3.4), die zum Einstecken des ersten Leiterplattenelements (6) ausgebildet ist, und mit mindestens einer auf diesem Substrat angeordneten, sich bis zu der Aussparung erstreckenden zweiten Leiterbahn (4.1-4.3, 8.3-8.6) umfasst; und
Stecken des ersten Leiterplattenelements (6) in das zweite Leiterplattenelement (1), so dass die erste Leiterbahn (12.1, 12.2) die zweite Leiterbahn (4.1-4.3, 8.3-8.6) ergänzt.

13. Verfahren nach Anspruch 12, **dadurch gekennzeichnet, dass** Verbindungsstellen der ersten Leiterbahn (12.1, 12.2) und der zweiten Leiterbahn (4.1-4.3, 8.3-8.6) verlötet werden.

14. Verfahren nach Anspruch 13 **dadurch gekennzeichnet, dass** das Verlöten mittels Wellenlötung durchgeführt wird.
